# EUROPÄISCHE PATENTSCHRIFT

(11) **EP 2 286 255 B1**
(45) Veröffentlichungstag und Bekanntmachung des Hinweises auf die Patenterteilung: **31.08.2011**
(21) Anmeldenummer: 09761435.8
(22) Anmeldetag: 05.06.2009
(51) Int. Cl.: G01R 31/12, G01R 29/08, G01R 31/14

(54) **Prüfanordnung zur Stossspannungsprüfung von elektrischen Hochspannungskomponenten**
Test assembly for surge voltage testing of high voltage electrical components
Dispositif d'essai pour des composants électriques à haute tension par tension de choc

(30) Priorität: 12.06.2008 EP 08010755
(43) Veröffentlichungstag der Anmeldung: 23.02.2011
(73) Patentinhaber: ABB Technology AG, 8050 Zürich (CH)
(72) Erfinder: STEIGER, Matthias, 06779 Schierau (DE); WERLE, Peter, 29664 Walsrode (DE)
(74) Vertreter: Partner, Lothar
(86) Internationale Anmeldenummer: PCT/EP2009/004048
(87) Internationale Veröffentlichungsnummer: WO 2009/149872

(56) Entgegenhaltungen:
- DE-A1- 19 639 023
- HAEFELY HIGH VOLTAGE TEST: "Impulse Voltage Test System SGSA 100-800 kV, 5-40 KJ" 19000101, [Online] 1. Januar 2001 (2001-01-01), XP009109093 Gefunden im Internet: URL:http://web.archive.org/web/20070326174 534/http://www.haefely.com/10-products/10- impulse-voltage-testing.php> [gefunden am 2008-11-24]
- SCHUFFT W ET AL: "Frequency-tuned resonant test systems for on-site testing and diagnostics of extruded cables" HIGH VOLTAGE ENGINEERING, 1999. ELEVENTH INTERNATIONAL SYMPOSIUM ON (C ONF. PUBL. NO. 467) LONDON, UK 23-27 AUG. 1999, LONDON, UK,IEE, UK, Bd. 5, 23. August 1999 (1999-08-23), Seiten 335-339, XP006501811 ISBN: 978-0-85296-719-5
- KLAUS SCHWENK ET AL: "Load range extension methods for lightning impulse testing with high voltage impulse generators" INTERNET CITATION, [Online] 26. März 2007 (2007-03-26), XP007910341 Gefunden im Internet: URL:http://www.haefely.com/pdf/T02E01-pape r.pdf> [gefunden am 2009-10-28]
- M. LOPPACHER: "On-site Impulse Tests and corresponding State of the Art Measurement and Analysis Techniques for Power Transformers" 19000101, [Online] 1. Januar 1999 (1999-01-01), XP009109097 Gefunden im Internet: URL:http://web.archive.org/web/20060316135 407/http://www.haefely.com/pdf/scientific/ e1-95.pdf> [gefunden am 2008-11-24]
- SCHIERIG S ET AL: "HV AC generation based on resonant circuits with variable frequency for testing of electrical power equipment on site" CONDITION MONITORING AND DIAGNOSIS, 2008. CMD 2008. INTERNATIONAL CONFERENCE ON, IEEE, PISCATAWAY, NJ, USA, 21. April 2008 (2008-04-21), Seiten 684-691, XP031292593 ISBN: 978-1-4244-1621-9
- WINTER A ET AL: "A mobile transformer test system based on a stativ frequency converter" INTERNET CITATION, 27. August 2007 (2007-08-27), XP002500564

## Beschreibung

Die Erfindung betrifft eine Prüfanordnung zur Stossspannungsprüfung von elektrischen Hochspannungskomponenten mit einem Stossspannungsgenerator in Form einer turmähnlichen Struktur.

Es ist allgemein bekannt, dass zur Prüfung von Hochspannungskomponenten, insbesondere von Leistungstransformatoren, Stossspannungsgeneratoren verwendet werden. Mittels eines Stossspannungsgenerators ist ein Spannungsimpuls erzeugbar, welcher mittels geeigneter elektrischer Verschaltung von Stossspannungsgenerator und Prüfling dem zu testenden Teil des Prüflings, beispielsweise einer Hochspannungswicklung, zugeführt wird. Ein derartiger Spannungsimpuls weist eine zeitliche Dauer im Bereich von üblicherweise bis zu einigen 10µs auf, die maximale Spannung beträgt - je nach Prüfling - bis zu einige MV. Aus der kontinuierlichen Messung von Strom und/oder Spannungswerten innerhalb der elektrischen Verschaltung des Testaufbaus bei Einwirken des Spannungsimpulses sind Aufschlüsse über den Zustand der geprüften Komponente ableitbar, beispielsweise auf den Alterungszustand oder auch einen Fehler in der elektrischen Isolation.

Ein Stossspannungsgenerator weist eine Vielzahl von Kondensatoren auf, welche zur Erzeugung eines Hochspannungsimpulses zunächst in elektrischer Parallelschaltung geladen werden und anschließend in elektrischer Reihenschaltung entladen werden. Durch die Reihenschaltung sind entsprechend höhere Spannungen realisierbar. Die Ausführungsform eines Stossspannungsgenerators ist gemäß dem allgemeinen Stand der Technik zumeist in einer turmähnlichen Struktur, in welcher die verwendeten Komponenten Kondensator, Widerstand, Funkenstrecke sowie Isolatoren in einer Gitterstruktur zusammengefügt sind. Die Isolatoren sind auch als Rohre aus einem Isolationsmaterial, beispielsweise GFK, ausführbar, wobei die Isolatoren vorzugsweise längs der turmähnlichen Struktur hintereinander in Form von mehreren sich über die gesamte Länge der Struktur erstreckenden Stützsäulen angeordnet sind und die elektrischen Komponenten quer dazu. Stossspannungsgeneratoren sind in aller Regel nur im senkrechten, aufrechten Zustand zu betreiben, weil nur so alle notwendigen Isolationsabstände zum angrenzenden geerdeten Potential eingehalten sind. Die höchste Spannung tritt an der Spitze des Stossspannungsgenerators auf.

Hochspannungskomponenten wie Leistungstransformatoren weisen ein sehr hohes Gewicht auf, je nach elektrischer Nennleistung auch mehrere 100t. Ein Transport eines derartigen innerhalb eines elektrischen Energieverteilungsnetzes eingebauten Transformators in ein fest installiertes Prüffeld, in welchem im Rahmen einer Stossspannungsprüfung der Transformator im Rahmen einer Wartung oder zu diagnostischen Zwecken geprüft werden könnte, ist aufgrund des hohen Transportaufwandes für den jeweiligen Transformator praktisch ausgeschlossen. Zudem ist in den seltensten Fällen genügend Redundanz in einem Energieverteilungsnetz vorhanden, dass ein Transformator ohne Beeinträchtigung des Netzbetriebes ausgebaut werden könnte.

Aus diesem Grund erfolgen derartige Stossspannungsprüfungen von Leistungstransformatoren zumeist vor Ort. Die Prüfanordnung mit Stossspannungsgenerator sowie weiteren für die Prüfung benötigten Komponenten wie Spannungsteiler, Mess- und Auswertevorrichtungen wird in mehreren Baugruppen zu dem Ort, an dem sich der zu prüfende beziehungsweise zu wartende Transformator befindet, transportiert und dort zu einer Prüfanordnung montiert. Insbesondere der Spannungsteiler, welcher zur Messung der hohen Spannungen von beispielsweise bis zu 2MV benötigt wird, ist neben dem Stossspannungsgenerator eine Komponente von beachtlicher Größe, beispielsweise einer Höhe von 10m.

Aus den Veröffentlichungen M.Loppacher: "On-site Impulse Tests and Corresponding State of the Art Measurement and Analysis Techniques for Power Transformers" vom 01.01.1999 und Haefely High Voltage Test: "Impulse Voltage Test System SGSA 100-800kV, 5-40 kJ" vom 01.01.2001 ist eine Prüfanordnung zur Stossspannungsprüfung von elektrischen Hochspannungskomponenten bekannt geworden, welche für den mobilen Einsatz konzipiert ist und in horizontaler Lage zum Einsatzort transportiert wird, wo sie dann mittels eines hydraulischen Kippmechanismus aufgerichtet wird.

In bestimmten Varianten einer Prüfschaltung für Stossspannungsprüfungen ist ein Überspannungsbegrenzer vorgesehen, welcher die Stossspannung ab einer bestimmten Höhe des ansteigenden Stossspannungsimpulses abschneidet. Derartige Überspannungsbegrenzer sind bedarfsweise als separate Komponente in die jeweilige Prüfanordnung einzubringen und stellen ein säulenähnliches Element von einer beachtlichen Höhe dar.

Nachteilig hierbei ist, dass die Montage vor Ort mit einem erheblichen Zeitaufwand verbunden ist. Insbesondere die Positionierung und Montage eines Stossspannungsgenerators, eines Überspannungsbegrenzers oder eines Spannungsteilers ist sehr zeitaufwändig.

Ausgehend von diesem Stand der Technik ist es Aufgabe der Erfindung, eine Prüfanordnung zur Stossspannungsprüfung von elektrischen Hochspannungskomponenten anzugeben, welche den benötigten Zeitaufwand für eine Vor-Ort-Montage reduziert.

Diese Aufgabe wird erfindungsgemäß gelöst durch eine Prüfanordnung mit den im Anspruch 1 angegebenen Merkmalen. Demgemäß ist die erfindungsgemäße Prüfanordnung unter anderen dadurch gekennzeichnet, dass der Stossspannungsgenerator zwischen einer ersten annähernd waagerechten Position innerhalb eines quaderförmigen Behälters, welcher ein erstes und ein zweites Behälterende aufweist, und einer jeweils annähernd senkrechten Position relativ zum Behälter bewegbar ist, dass eine jeweilige Bewegung zwischen den beiden jeweiligen Positionen eine Schwenkbewegung um eine jeweilige Drehachse quer zur Längsrichtung des Stossspannungsgenerators beinhaltet und dass der Behälter an seiner oberen Seite durch wenigstens eine bewegbare Abdeckung verschließbar ist

Somit ist es möglich, die gesamte Prüfanordnung innerhalb eines einzigen Behälters anzuordnen und zu transportieren. Der Transport erfolgt vorzugsweise in der waagerechten Position des Stossspannungsgenerators, so dass sich alle wesentlichen Komponenten der Prüfanordnung innerhalb der Begrenzung des Behälters befinden.

Die im Betrieb isolationstechnisch notwendigen Abstände vom Stossspannungsgenerator zu geerdeten Komponenten, beispielsweise einer Seitenwand des Behälters oder dem angrenzenden Erdreich, ist in dieser waagerechten Position nicht gegeben.

Durch die Schwenkbewegung des Stossspannungsgenerators in eine senkrechte Position sind die isolationstechnisch notwendigen Abstände zu den genannten geerdeten Komponenten gegeben. Eine derartige Schwenkbewegung erfolgt nach Platzierung des Behälters vor Ort in unmittelbarer Nähe zu der zu prüfenden Hochspannungskomponente, beispielsweise in einem Abstand von 5m bis 30m

In vorteilhafter Weise ist so eine komplette Prüfanordnung zur Stossspannungsprüfung transportierbar und mit geringem Aufwand in Betrieb zu nehmen.

In einer weiteren Ausgestaltung der Prüfanordnung nach Anspruch ist wenigstens ein Überspannungsbegrenzer zusammen mit dem Hochspannungsgenerator zwischen einer annähernd waagerechten Position innerhalb des Behälters und einer annähernd senkrechten Position schwenkbar. Überspannungsbegrenzer weisen üblicherweise eine langgestreckte Struktur beachtlicher Größe auf, welche den Aufbau der Prüfanordnung vor Ort erschwert. Eine gemeinsame Schwenkbewegung zusammen mit dem Stossspannungsgenerator ermöglicht dieselben Vorteile wie bereits zuvor bei dem Stossspannungsgenerator beschrieben.

Entsprechend einer erfindungsgemäßen Variante der Prüfanordnung weist der Überspannungsbegrenzer wenigstens eine Funkenstrecke auf. Es ist aber auch durchaus mögliche, mehrere Funkenstrecken in Reihe zu schalten. Die Funkenstrecken sind derart dimensioniert, dass bei Überschreiten einer bestimmten Spannung, welche elektrisch an einer Seite des Spannungsteilers anliegt, ein Durchschlag erfolgt, wobei die andere Seite üblicherweise geerdet ist. Somit wird der Stossspannungsimpuls ab einer bestimmten Spannungshöhe kurzgeschlossen. Zur Begrenzung des Kurzschlussstromes sind bedarfsweise elektrische Widerstände in Reihe mit den Funkenstrecken zu schalten. Die Reihenschaltung mehrerer Funkenstrecken und Widerstände begründet eine langgestreckte Struktur eines derartigen Überspannungsbegrenzers, beispielsweise mehrere Meter.

In einer weiteren Ausgestaltung der erfindungsgemäßen Prüfanordnung weist der Überspannungsbegrenzer wenigstens ein Halbleiterelement auf, welches ebenfalls die längs seiner beiden Anschlüsse anliegende elektrische Spannung begrenzt, ähnlich beispielsweise eine Zener-Diode in der Elektronik. Vorzugsweise sind auch hier mehrere Elemente elektrisch in Reihe geschaltet, bedarfsweise auch mit elektrischen Widerständen, so dass sich auch für einen derartigen Überspannungsbegrenzer eine längliche Struktur ergibt. Eine Kombination mit einer Funkenstrecke ist selbstverständlich möglich.

In einer bevorzugten Variante der erfindungsgemäßen Prüfanordnung ist der Überspannungsbegrenzer im Inneren der turmähnlichen Struktur des Stossspannungsgenerators angeordnet. Die langgestreckte und zumeist säulenähnliche Struktur eines Überspannungsbegrenzers ist vorteilhafter Weise in den formähnlichen, inneren, ungenutzten Bereich des Stossspannungsgenerators integrierbar. Dieser weist nämlich beispielsweise drei oder vier sich über dessen gesamte Höhe erstreckende Isolatorsäulen auf. Die elektrischen Komponenten des Stossspannungsgenerators sind strebenartig zwischen den Säulen angeordnet, so dass der von diesen umgrenzte Innenraum seither ungenutzt ist.

Somit ist es möglich, eine platzintensive Komponente wie einen Überspannungsbegrenzer in einen zuvor ungenutzten Raum zu integrieren. Zur Wahrung maximaler Abstände zu benachbarten Komponenten des Stossspannungsgenerators ist der Überspannungsbegrenzer vorzugsweise genau in die Mitte der Grundfläche der turmähnlichen Struktur des Stossspannungsgenerators anzuordnen. In vorteilhafter Weise ist zudem keine zusätzliche Schwenkvorrichtung notwendig weil diejenige für den Stossspannungsgenerator verwendet wird.

In einer weiteren Variante der Prüfanordnung ist der Überspannungsbegrenzer in die turmähnliche Struktur des Stossspannungsgenerators integriert. Die Integration der elektrisch in Reihe geschalteten Einzelkomponenten wie beispielsweise Widerstand, Funkenstrecke und/oder Halbleiterelement in die Turmstruktur erfolgt hierbei beispielsweise als Strebe zwischen den Isolatorsäulen, es ist aber auch durchaus eine Integration von Einzelkomponenten in eine oder mehrere Isolatorensäulen selbst denkbar. Isolatorsäulenelemente sind nämlich zumeist hohlzylindrisch ausgeprägt, so dass im inneren Hohlraum ebenfalls seither ungenutzter Raum ist.

Vorzugsweise ist die elektrische Reihenschaltung der Einzelkomponenten eines derartiger Überspannungsbegrenzer längs der gesamten Erstreckung des Stossspannungsgenerators angeordnet, also zwischen dessen ersten und zweiten Strukturende. Auf diese Weise ist das Risiko eines elektrischen Überschlags zwischen Komponenten des Stossspannungsgenerators und den Einzelkomponenten des in diesen integrierten Überspannungsbegrenzers aufgrund der geringeren elektrischen Potentialdifferenzen zueinander reduziert.

In ähnlicher Weise ist auch eine Prüfanordnung vorgesehen, bei welcher ein - vorzugsweise säulenartig ausgeprägter - Überspannungsbegrenzer im äußeren Bereich des Stossspannungsgenerators in paralleler Ausrichtung hierzu angeordnet ist. Eine derartige Anordnung ist insbesondere dann von Vorteil, wenn der Überspannungsbegrenzer und der Stossspannungsgenerator mittels einer längenverstellbaren und quer zu deren parallelen Längsachsen wirkenden Bewegungsvorrichtung miteinander verbunden sind.

Somit ist es möglich, den Überspannungsbegrenzer und den Hochspannungsgenerator platzsparend waagerecht zu transportieren und nach deren gemeinsamen Aufrichten in eine senkrechte Position axial auseinander zu bewegen, so dass ein isolationstechnisch günstiger Mindestabstand für den Prüfbetrieb erreicht ist.

In vergleichbarer Weise ist eine weitere erfindungsgemäße Prüfanordnung dadurch gekennzeichnet, dass ein Spannungsteiler zusammen mit dem Stossspannungsgenerator zwischen einer annähernd waagerechten Position innerhalb des Behälters und einer annähernd senkrechten Position schwenkbar ist.

Ein Spannungsteiler ist eine ebenfalls säulenähnliche langgestreckte elektrische Komponente, so dass sich ähnliche Vorteile ergeben wie bei einem vergleichbar angeordneten Überspannungsbegrenzer. Demgemäß ist erfindungsgemäß ebenfalls vorgesehen, dass der Spannungsteiler und der Stossspannungsgenerator mittels einer längenverstellbaren und quer zu deren parallelen Längsachsen wirkenden Bewegungsvorrichtung miteinander verbunden sind. Selbstverständlich ist es möglich, sowohl einen Spannungsteiler als auch einen Überspannungsbegrenzer mit einer jeweiligen separaten linearen Bewegungsvorrichtung nach dem gemeinsamen Aufrichten mit dem Stossspannungsgenerator axial von diesem wegzubewegen.

In einer weiteren Variante der Prüfanordnung ist der Behälter ein transportierbarer Container, welcher an jeder seiner sechs Seiten zumindest teilweise durch Wände oder Wandsegmente begrenzt ist. Besonders bevorzugt ist die Ausführung des Containers als 40-Fuß Container.

Ein Container mit der Standardabmessung 40-Fuß ist besonders geeignet, mittels üblicher Transportmittel, wie beispielsweise Schiff, Eisenbahn oder LKW transportiert zu werden. Die Länge von 40 Fuß entspricht der größten verfügbaren Länge eines Standardcontainers und ist unwesentlich größer als die für die Unterbringung eines Stossspannungsgenerators bzw. Spannungsteilers benötigte Länge von ca. 10m. Prüfanordnungen mit geringeren Längen von Stossspannungsgenerator bzw. Spannungsteiler sind entsprechend auch in kürzeren Containern anordenbar.

In einer besonders bevorzugten Ausgestaltung der Prüfanordnung ist der Container zugelassen gemäß CSC (Container Safety Convention). Dies bedeutet beispielsweise, dass der Container bei der Verladung auf ein Containerschiff in jeder beliebigen Stapelposition angeordnet werden kann. Der Transport der Prüfanordnung wird dadurch weiter vereinfacht.

Weitere vorteilhafte Ausgestaltungsmöglichkeiten sind den weiteren abhängigen Ansprüchen zu entnehmen.

Anhand der in den Zeichnungen dargestellten Ausführungsbeispiele sollen die Erfindung, weitere Ausführungsformen und weitere Vorteile näher beschrieben werden.

Es zeigen:
- Fig. 1: eine Prüfanordnung mit waagerechtem Stossspannungsgenerator,
- Fig. 2: dieselbe Prüfanordnung mit senkrechtem Stossspannungsgenerator sowie
- Fig. 3: eine Draufsicht auf eine zweite Prüfanordnung

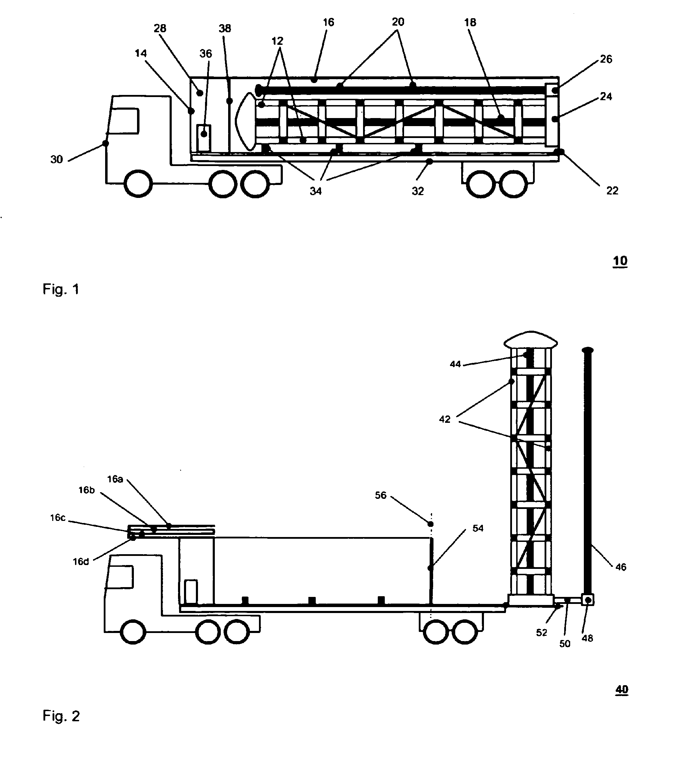

Fig. 1 zeigt eine Prüfanordnung 10. In einem quaderförmigen Behälter 14, in diesem Fall ein auf einem LKW-Auflieger 32 befindlicher 40 Fuß Standard Container mit CSC Zulassung, ist in Stossspannungsgenerator 12 in waagerechter Position angeordnet. Dieser weist vier Stützsäulen aus mehreren Isolatorelementen, beispielsweise aus Keramik, sowie eine turmähnliche Struktur mit Querverstrebungen auf, wobei die Querverstrebungen zumeist aus elektrischen Komponenten des Stossspannungsgenerators 12 gebildet sind, beispielsweise Widerständen. Am seinem rechten Ende ist der Stossspannungsgenerator, welcher in dieser Position auf Stützelementen 34 aufliegt, auf einem Sockelelement 24 montiert, welches in diesem Fall an eine Stirnfläche des Containers 14 angrenzt. Parallel zur länglichen Erstreckung des Stossspannungsgenerators 12 ist ein Spannungsteiler 20 in waagerechter Position gezeigt. Dieser ist auf einem Sockelelement 26 montiert, welches über eine nicht gezeigte lineare Bewegungsvorrichtung mit dem Sockelelement 24 des Stossspannungsgenerators 12 verbunden ist. An der anderen Seite des Hochspannungsgenerators 12 ist ohne Bezugszeichen eine Steuerelektrode angedeutet.

Das Sockelelement 24 ist um die Drehachse 22 schwenkbar, so dass der Stossspannungsgenerator und die mit ihm starr verbundenen in eine senkrechte Position schwenkbar sind. Im Inneren Bereich des Stossspannungsgenerators 12 ist mittig ein Überspannungsbegrenzer 18 gezeigt. Dieser ist in diesem Fall durch eine Reihenschaltung einer Funkenstrecke mit mehreren Halbleiterelementen und Widerständen realisiert, wobei diese Elemente summarisch in einer säulenähnlichen Struktur ausgeprägt sind, welche sich längs der Erstreckung des Stossspannungsgenerators stets in dessen Mitte befindet.

Der Container 14 ist in seinem oberen Dachbereich von einer Abdeckung 16 begrenzt, welche öffen- und schließbar ist. Im rechten Bereich des Containers 14 ist durch eine Trennwand 38 abgetrennt ein Messraum 28 vorgesehen, welcher u.a. auch eine Messvorrichtung 36 beinhaltet, welche in diesem Beispiel allerdings nur schematisch angedeutet ist.

Fig. 2 zeigt dieselbe Prüfanordnung mit demselben Stossspannungsgenerator in senkrechter Position 42. Der innerhalb des Stossspannungsgenerators starr zu diesem angeordnete Überspannungsbegrenzer ist nunmehr in senkrechter Position 44 gezeigt, ebenso wie der Spannungsteiler 46. In dieser Darstellung sind die Sockelelemente des Stossspannungsgenerators 42 und des Spannungsteilers 46 mittels einer längenverstellbaren Bewegungsvorrichtung 50 auseinander bewegt worden, so dass axiale der Abstand zwischen Spannungsteiler 46 und Stossspannungsgenerator 42 hinreichend groß ist, um einen Prüfbetrieb mit Hochspannung ohne Durchschläge zu gewährleisten.

Die Seitenwand 54 des Containers ist im seinem hinteren Bereich um die Kippachse 56 nach außen geklappt. Die das Containerdach bildenden Segmente 16a, b, c, d sind im vorderen Bereich des Containers über dem Dach des LKW schwebend zusammengefaltet dargestellt. Somit ist insbesondere das Herausschwenken des Stossspannungsgenerators aus dem Container ermöglicht.

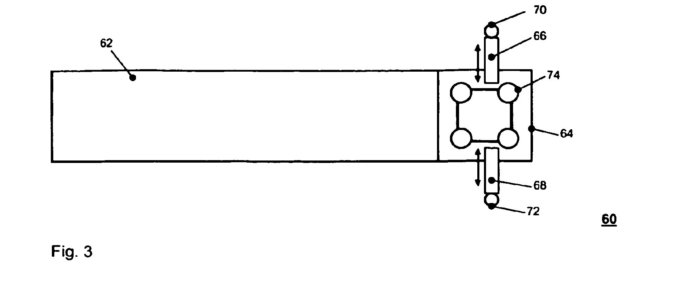

Fig. 3 zeigt eine Draufsicht auf eine zweite Prüfanordnung 60 mit einem zweiten Stossspannungsgenerator 74, einem zweiten Überspannungsbegrenzer 72 und einem zweiten Spannungsteiler 70. Die rechte Stirnseitenwand 64 eines zweiten quaderförmigen Behälters 62 ist in eine waagerechte Position geschwenkt. Demgemäß ist der senkrecht dazu angeordnete zweite Stossspannungsgenerator 74, der zweite Überspannungsbegrenzer 72 und der Spannungsteiler 70 in eine senkrechte Position aus dem Behälter 62 geschwenkt, so dass lediglich die Grundrisse der genannten Komponenten angedeutet sind. Der zweite Spannungsteiler 70 sowie der zweite Überspannungsbegrenzer 72 sind mit einer jeweiligen linearen Bewegungsvorrichtung 66, 68 jeweils axial von dem Stossspannungsgenerator 74 wegbewegt worden, so dass sich ein hinreichender Isolationsabstand zwischen diesen Komponenten ergibt.

Selbstverständlich sind auch andere Bewegungsvorrichtungen 66, 68 denkbar, welche ihrerseits beispielsweise ebenfalls eine Schwenkbewegung ausführen können. In jedem Fall muss eine derartige Bewegungsvorrichtung ein Verändern des Abstandes vom Stossspannungsgenerator 74 bewirken.

### Bezugszeichenliste

- 10: Prüfanordnung mit waagerechtem Stossspannungsgenerator
- 12: Stossspannungsgenerator in waagerechter Position
- 14: Quaderförmiger Behälter
- 16: geschlossene Abdeckung
- 16a-d: geöffnete Abdeckung
- 18: Überspannungsbegrenzer in waagerechter Position
- 20: Spannungsteiler in waagerechter Position
- 22: Drehachse
- 24: Sockelelement des Stossspannungsgenerators
- 26: Sockelelement des Spannungswandlers
- 28: Messraum
- 30: LKW
- 32: LKW-Auflieger
- 34: Stützelemente
- 36: Messvorrichtung
- 38: Trennwand
- 40: Prüfanordnung mit senkrechtem Stossspannungsgenerator
- 42: Stossspannungsgenerator in senkrechter Position
- 44: Überspannungsbegrenzer in senkrechter Position
- 46: Spannungswandler in waagerechter Position
- 48: herausgefahrenes Sockelelement des Spannungswandlers
- 50: längenverstellbare Bewegungsvorrichtung
- 52: heruntergeklappte Behälterrückwand
- 54: aufgeklapptes Seitenwandelement
- 56: Klappachse
- 60: zweite Prüfanordnung
- 62: zweiter quaderförmiger Behälter
- 64: geklappte Stirnwand
- 66: zweite lineare Bewegungsvorrichtung
- 68: dritte lineare Bewegungsvorrichtung
- 70: zweiter Spannungsteiler
- 72: zweiter Überspannungsbegrenzer
- 74: zweiter Stossspannungsgenerator

## Patentansprüche

1. Prüfanordnung (10, 40, 60) zur Stossspannungsprüfung von elektrischen Hochspannungskomponenten, umfassend
• einen Stossspannungsgenerator (12, 42, 74) in Form einer turmähnlichen Struktur,
• einen quaderförmigen Behälter (14, 62), welcher ein erstes und ein zweites Behälterende sowie wenigstens eine bewegbare Abdeckung aufweist,
• einen Überspannungsbegrenzer (18, 44, 72), welcher außerhalb der turmähnlichen Struktur des Stossspannungsgenerators angeordnet und parallel hierzu ausgerichtet ist,
• eine Bewegungsvorrichtung (50, 66, 68),
**dadurch gekennzeichnet, dass** der Stossspannungsgenerator (12, 42, 74) zusammen mit dem Überspannungsbegrenzer (18, 44, 72) zwischen einer ersten annähernd waagerechten Position (12) innerhalb des quaderförmigen Behälters (14, 62) und einer jeweils annähernd senkrechten Position (42) relativ zum waagerechten Behälter (14, 62) bewegbar ist, dass eine jeweilige Bewegung zwischen den beiden jeweiligen Positionen eine Schwenkbewegung um eine jeweilige Drehachse (22) quer zur Längsrichtung des Stossspannungsgenerators (12, 42, 74) beinhaltet, dass der Behälter (14, 62) an seiner oberen Seite durch die wenigstens eine bewegbare Abdeckung (16, 16a, 16b, 16c, 16d) verschließbar ist und dass der Überspannungsbegrenzer (18, 44, 72) und der Stossspannungsgenerator (12, 42, 74) mittels der längenverstellbaren und quer zu deren parallelen Längsachsen wirkenden Bewegungsvorrichtung (50, 66, 68) miteinander verbunden sind.

2. Prüfanordnung nach Anspruch 2, **dadurch gekennzeichnet, dass** der Überspannungsbegrenzer (18, 44, 72) wenigstens eine Funkenstrecke aufweist.

3. Prüfanordnung nach einem der Ansprüche 1 oder 2, **dadurch gekennzeichnet, dass** der Überspannungsbegrenzer (18, 44, 72) wenigstens ein Halbleiterelement aufweist.

4. Prüfanordnung nach einem der vorherigen Ansprüche, **dadurch gekennzeichnet, dass** der Überspannungsbegrenzer (18, 44, 72) außerhalb der turmähnlichen Struktur des Stossspannungsgenerators (12, 42, 74) angeordnet und parallel hierzu ausgerichtet ist. ,

5. Prüfanordnung nach einem der vorherigen Ansprüche, **dadurch gekennzeichnet, dass** diese einen Spannungsteiler (20, 46, 70) umfasst, welcher zusammen mit dem Stossspannungsgenerator (12, 42, 74) zwischen einer annähernd waagerechten Position (20) innerhalb des Behälters (14, 62) und einer annähernd senkrechten Position (46) schwenkbar ist.

6. Prüfanordnung nach Anspruch 5, **dadurch gekennzeichnet, dass** der Spannungsteiler (20, 46, 70) und der Stossspannungsgenerator (12, 42, 74) mittels einer weiteren längenverstellbaren und quer zu deren parallelen Längsachsen wirkenden Bewegungsvorrichtung (50, 66, 68) miteinander verbunden sind.

7. Prüfanordnung nach einem der vorherigen Ansprüche, **dadurch gekennzeichnet, dass** der Behälter (14, 62) ein Container ist.

## Claims

1. Test arrangement (10, 40, 60) for impulse voltage testing of electrical high-voltage components comprising
• an impulse voltage generator (12, 42, 74) in the form of a tower-like structure,
• a cuboid container (14, 62), which has a first and a second container end and at least one movable cover,
• a surge arrester (18, 44, 72) which is arranged outside the structure, which is similar to a tower, of the impulse voltage generator and is aligned parallel to it,
• a movement apparatus (50,66,68),
**characterized in that** the impulse voltage generator (12, 42, 74) can be moved together with the surge arrester (18, 44, 72) between a first approximately horizontal position (12) within the cuboid container (14, 62) and a respectively approximately vertical position (42) relative to the horizontal container (14, 62), **in that** a respective movement between the two respective positions includes a pivoting movement about a respective rotation axis (22) transversely with respect to the longitudinal direction of the impulse voltage generator (12, 42, 74), **in that** the container (14, 62) is closable on its upper face by the at least one movable cover (16, 16a, 16b, 16c, 16d), and **in that** the surge arrester (18, 44, 72) and the impulse voltage generator (12, 42, 74) are connected to one another by the variable-length movement apparatus (50, 66, 68) which acts transversely with respect to their parallel longitudinal axes.

2. Test arrangement according to Claim 1, **characterized in that** the surge arrester (18, 44, 72) has at least one spark gap.

3. Test arrangement according to one of Claims 1 or 2, **characterized in that** the surge arrester (18, 44, 72) has at least one semiconductor element.

4. Test arrangement according to one of the preceding claims, **characterized in that** the surge arrester (18, 44, 72) is arranged outside the structure, which is similar to a tower, of the impulse voltage generator (12, 42, 74) and is aligned parallel to it.

5. Test arrangement according to one of the preceding claims, **characterized in that** this test arrangement comprises a voltage divider (20, 46, 70) which is pivotable together with the impulse voltage generator (12, 42, 74) between an approximately horizontal position (20) within the container (14, 62) and an approximately vertical position (46).

6. Test arrangement according to Claim 5, **characterized in that** the voltage divider (20, 46, 70) and the impulse voltage generator (12, 42, 74) are connected to one another by a further variable-length movement apparatus (50, 66, 68) which acts transversely with respect to their parallel longitudinal axes.

7. Test arrangement according to one of the preceding claims, **characterized in that** the container (14, 62) is a standard freight container.

## Revendications

1. Arrangement de contrôle (10, 40, 60) pour le contrôle de la tension de choc de composants électriques à haute tension, comprenant
* un générateur de tension de choc (12, 42, 74) sous la forme d'une structure similaire à une tour,
* un récipient (14, 62) de forme parallélépipédique qui présente une première et une deuxième extrémité de récipient ainsi qu'au moins une couverture amovible,
* un limiteur de surtension (18, 44, 72) qui est disposé à l'extérieur de la structure similaire à une tour du générateur de tension de choc et qui est orienté parallèlement à celle-ci,
* un dispositif de déplacement (50, 66, 68)
**caractérisé en ce que** le générateur de tension de choc (12, 42, 74), conjointement avec le limiteur de surtension (18, 44, 72), peut être déplacé entre une première position (12) approximativement horizontale à l'intérieur du récipient (14, 62) parallélépipédique et une position (42) à chaque fois approximativement verticale par rapport au récipient (14, 62) horizontal, **en ce qu'**un mouvement respectif entre les deux positions respectives contient un mouvement de pivotement autour d'un axe de rotation (22) correspondant transversal par rapport au sens longitudinal du générateur de tension de choc (12, 42, 74), **en ce que** le récipient (14, 62) peut être fermé sur son côté supérieur par l'au moins une couverture (16, 16a, 16b, 16c, 16d) mobile et **en ce que** le limiteur de surtension (18, 44, 72) et le générateur de tension de choc (12, 42, 74) sont reliés entre eux au moyen du dispositif de déplacement (50, 66, 68) positionnable en longueur et agissant transversalement à leurs axes longitudinaux parallèles.

2. Arrangement de contrôle selon la revendication 1, **caractérisé en ce que** le limiteur de surtension (18, 44, 72) présente au moins un éclateur.

3. Arrangement de contrôle selon l'une des revendications 1 ou 2, **caractérisé en ce que** le limiteur de surtension (18, 44, 72) présente au moins un élément semiconducteur.

4. Arrangement de contrôle selon l'une des revendications précédentes, **caractérisé en ce que** le limiteur de surtension (18, 44, 72) est disposé à l'extérieur de la structure similaire à une tour du générateur de tension de choc (12, 42, 74) et orienté parallèlement à.celle-ci.

5. Arrangement de contrôle selon l'une des revendications précédentes, **caractérisé en ce que** celui-ci comprend un diviseur de tension (20, 46, 70) qui, conjointement avec le générateur de tension de choc (12, 42, 74), peut être pivoté entre une position (20) approximativement horizontale à l'intérieur du récipient (14, 62) et une position (46) approximativement verticale.

6. Arrangement de contrôle selon la revendication 5, **caractérisé en ce que** le diviseur de tension (20, 46, 70) et le générateur de tension de choc (12, 42, 74) sont reliés entre eux au moyen d'un dispositif de déplacement supplémentaire (50, 66, 68) positionnable en longueur et agissant transversalement à leurs axes longitudinaux parallèles.

7. Arrangement de contrôle selon l'une des revendications précédentes, **caractérisé en ce que** le récipient (14, 62) est un conteneur.
